# EUROPÄISCHE PATENTSCHRIFT

(11) **EP 0 456 321 B1**
(45) Veröffentlichungstag und Bekanntmachung des Hinweises auf die Patenterteilung: **13.12.1995**
(21) Anmeldenummer: 91201074.1
(22) Anmeldetag: 06.05.1991
(51) Int. Cl.: H03G 5/02, H03G 5/04, H03G 3/00

(54) **Schaltungsanordnung mit elektronisch steuerbarem Übertragungsverhalten**
Circuit with controlled transfer characteristic
Circuit comprenant une caractéristique de transfert commandée

(30) Priorität: 10.05.1990 DE 4015019
(43) Veröffentlichungstag der Anmeldung: 13.11.1991
(73) Patentinhaber: Philips Patentverwaltung GmbH, 22335 Hamburg (DE); Philips Electronics N.V., 5621 BA Eindhoven (NL)
(72) Erfinder: Kilian, Ernst-August, W-2000 Hamburg 61 (DE)
(74) Vertreter: von Laue, Hanns-Ulrich, Dipl.-Ing.

(56) Entgegenhaltungen:
- EP-A- 0 091 160
- DE-A- 3 935 051
- GB-A- 2 054 994
- GB-A- 2 085 686
- PATENT ABSTRACTS OF JAPAN vol. 7, no. 65 (E-165)(1210) 18. März 1983 & JP-A-57 211 815
- IEEE TRANSACTIONS ON CONSUMER ELECTRONICS, Bd. CE-33, Nr. 3, August 1987, New York, US, SS. 336-342; P. KIRCHLECHNER: "A serial bus controlled audioprocessor"
- INTER-ELECTRONIQUE, Bd. 25, Nr. 4, April 1970, Paris, FR, SS. 86-93; J.P. THERY: "Méthode de calcul d'un circuit en double-T ponté permettant la réalisation d'amplificateurs sélectifs de grande stabilité, à fréquence d'accord ajustable et à gain constant"
- PATENT ABSTRACTS OF JAPAN vol. 10, no. 213 (E-422)(2269) 25. Juli 1986 & JP-A-61 052 014

## Beschreibung

Die Erfindung betrifft eine Schaltungsanordnung mit elektronisch steuerbarem Übertragungsverhalten, insbesondere Stellerschaltung, wobei das Eingangssignal einem Verstärker mit steuerbarer Gegenkopplung zugeführt wird, an dessen Ausgang eine Spannungsteileranordnung mit frequenzabhängigem Verhalten angeschlossen ist, die mit mehreren Abgriffen versehen ist, die über einen ersten elektronisch steuerbaren Umschalter mit einem invertierenden Eingang des Verstärkers und über einen zweiten elektronisch steuerbaren Umschalter mit dem Ausgang der Schaltung verbunden sind.

Eine derartige Schaltungsanordnung ist aus der deutschen Patentschrift 31 32 402 bekannt. Bei dieser bekannten Anordnung erfolgt eine Beeinflussung des Frequenzganges des Eingangssignals durch geeignete Umschaltung der beiden elektronisch steuerbaren Umschalter. Die beiden Umschalter sind so gesteuert, daß für eine Anhebung des Eingangssignals in einem von dem frequenzabhängigen Spannungsteiler bestimmten Frequenzbereich der zweite Umschalter auf diejenige Position gesetzt wird, bei der das Signal mit dem größten Pegel ausgekoppelt wird. Eine Veränderung des Maßes der Anhebung wird vorgenommen durch Setzen des ersten Umschalters auf dessen verschiedene Positionen. Umgekehrt erfolgt eine Absenkung des Frequenzbereiches dadurch, daß der erste Schalter auf diejenige Position für maximale Gegenkopplung gesetzt und der Schalter 2 zwischen seinen verschiedenen Positionen betätigt wird. Bei dieser Anordnung ergibt sich vor allem bei frequenzabhängiger Beschaltung für z.B. Equalizer oder Tonsteller der Nachteil, daß je nach Maß der eingestellten Anhebung bzw. Absenkung immer ein bestimmter Frequenzbereich in gleicher Breite beeinflußt wird. Lediglich das Maß der Anhebung bzw. Absenkung verändert sich. Anders formuliert bedeutet dies nichts anderes, als das für relativ kleine Anhebungen bzw. Absenkungen die durch die Schaltungsanordnung vorgenommene Filterung eine geringere Güte aufweist als für stärkere Anhebungen bzw. Absenkungen in dem betreffenden Frequenzbereich. Als Güte wird hierbei das Verhältnis der Frequenz bei der maximalen Anhebung bzw. Absenkung zu der Frequenzdifferenz zwischen den Frequenzen bezeichnet, bei denen die Anhebung bzw. Absenkung einen gegenüber dem maximalen Wert und 3 dB geringeren Wert aufweist.

Es ist Aufgabe der Erfindung, eine Schaltungsanordnung anzugeben, welche in der Lage ist, auch relativ kleine Anhebungen bzw. Absenkungen mit der gleichen Filter-Güte vorzunehmen wie größere Anhebungen bzw. Absenkungen.

Diese Aufgabe ist erfindungsgemäß dadurch gelöst, daß die beiden Umschalter so gesteuert sind, daß
a) für eine Anhebung des Eingangssignals in einem von dem frequenzabhängigen Spannungsteiler bestimmten Frequenzbereich
   - der erste Umschalter auf eine solche Position gesetzt wird, daß die Anhebung in der gewünschten Frequenzbereichsbreite erfolgt, und daß
   - die Position des zweiten Umschalters so gewählt wird, daß die Anhebung in dem gewünschten Maß erfolgt, und daß
b) für eine Absenkung des Eingangssignals in dem von dem frequenzabhängigen Spannungsteiler bestimmten Frequenzbereich
   - der zweite Umschalter auf eine solche Position gesetzt wird, daß die Absenkung mit der gewünschten Frequenzbereichsbreite erfolgt, und daß
   - der erste Umschalter auf eine solche Position gesetzt wird, daß die Absenkung in dem gewünschten Maße erfolgt.

Der Erfindung liegt die Erkenntnis zugrunde, daß für eine Anhebung des Eingangssignals in dem von dem frequenzabhängigen Spannungsteiler bestimmten Frequenzbereich die Güte der dabei von der Schaltungsanordnung erzeugten Filterkurve von der Position des ersten Umschalters abhängt, also von dem Maß der Gegenkopplung vom Ausgang auf den invertierenden Eingang des Verstärkers. Durch geeignetes Setzen des ersten Umschalters kann also die Güte der entstehenden Filterkurve beeinflußt werden, d.h. also diejenige Frequenzbereichsbreite, in der eine Anhebung des Eingangssignals erfolgt. Das Maß der Anhebung wird dagegen durch Setzen des Umschalters 2 auf eine geeignete Position vorgenommen. Bei einer Anhebung des Eingangssignals in dem betreffenden Frequenzbereich beeinflussen verschiedene Postionen des Umschalters 2 nicht die Güte der entstehenden Filterkurven. Zusammenfassend ist also zu sagen, daß die Position des Schalters 1 die Güte der entstehenden Filterkurven bestimmt, während durch geeignete Steuerung des Umschalters 2 das Maß der Anhebung bestimmt wird.

Für eine Absenkung des Eingangssignals in dem Frequenzbereich liegen gerade umgekehrte Verhältnisse vor, da hier die Güte der entstehenden Filterkurven durch die Position des Umschalters 2 bestimmt wird. Der zweite Umschalter ist also auf eine solche Position zu setzen, daß die Absenkung mit der gewünschten Frequenzbereichsbreite bzw. Güte erfolgt. Das Maß der Absenkung wird nunmehr durch Setzen des ersten Umschalters auf eine geeignete Position vorgenommen.

In vielen Fällen wird es wünschenswert sein, eine Anhebung bzw. Absenkung in dem Frequenzbereich auch dann mit konstanter Güte vorzunehmen, wenn die Anhebung bzw. Absenkung in verschieden starkem Umfange erfolgt. Für das Beispiel der Anhebung bedeutet dies, daß der erste Umschalter auf eine feste Position gesetzt wird, die eine Anhebung in der gewünschten Frequenzbereichsbreite bzw. Güte zur Folge hat. Das Maß der Anhebung wird dann durch geeignetes Setzen des Umschalters 2 beeinflußt, wobei der Umschalter 1 in seiner Position verbleibt. Entsprechendes gilt für die Absenkung, bei der die Güte durch Setzen des Umschalters 2 in eine im folgenden beibehaltene Position vorgenommen wird und das Maß der Absenkung durch geeignetes Setzen des Umschalters 1 vorgenommen wird.

Die erfindungsgemäße Schaltungsanordnung gestattet es also, durch geeignetes Setzen der Umschalter nicht nur das Maß der Anhebung, sondern auch die Breite des beeinflußten Frequenzbereichs zu beeinflussen, d.h. also die Güte der entstehenden Filterkurven. Insbesondere ist es bei dieser Schaltungsanordnung nicht mehr so, daß für relativ geringe Anhebungen bzw. Absenkungen des Eingangssignals in dem Frequenzbereich die Güte der Filterkurven relativ geringe Werte aufweist.

In einer Ausgestaltung der Erfindung ist vorgesehen, daß für eine Anhebung des Eingangssignals in dem Frequenzbereich der erste Umschalter auf die Position für minimale Gegenkopplung gesetzt wird, und daß für eine Absenkung des Eingangssignals in dem Frequenzbereich der zweite Umschalter auf diejenige Position gesetzt wird, bei der die größte Dämpfung des Ausgangssignals erfolgt.

Da in vielen Anwendungsbereichen die Beeinflussung eines möglichst schmalen Frequenzbereichs gewünscht wird, und zwar insbesondere auch dann, wenn relativ kleine Anhebungen bzw. Absenkungen vorgenommen werden, ist es für diese Fälle vorteilhaft, die Umschalter so zu setzen, daß für verschiedene Beeinflussungen des Frequenzbereichs immer die maximal erreichbare Güte der entstehenden Filterkurven gegeben ist. Dies geschieht für Anhebungen des Eingangssignals in dem Frequenzbereich dadurch, daß der erste Umschalter auf die Position für minimale Gegenkopplung gesetzt wird, da hierbei für eine Anhebung des Eingangssignals Filterkurven mit maximaler Güte erzeugt werden. Umgekehrt gilt für die Absenkung des Eingangssignals, daß der zweite Umschalter auf diejenige Position gesetzt wird, bei der die größte Dämpfung des Ausgangssignals durch diesen Umschalter erfolgt. Für Absenkung des Eingangssignals wird in dieser Position des zweiten Umschalters maximale Güte der Filterkurven erzielt.

Diese Ausgestaltung ist insbesondere in denjenigen Fallen vorteilhaft, in denen ein möglichst schmaler Frequenzbereich auch dann beeinflußt werden soll, wenn nur geringe Anhebungen bzw. Absenkungen vorgenommen werden sollen, wie dies beispielsweise bei Equalizern der Fall ist.

Nach einer weiteren Ausgestaltung der Erfindung ist vorgesehen, daß als Umschalter Halbleiterschaltungen vorgesehen sind, deren Schaltzustände durch digitale Datenworte steuerbar sind. Es ist dadurch auf einfache Weise möglich, sowohl die Güte der entstehenden Filterkurven, d.h. also die Breite des beeinflußten Frequenzbereichs, wie auch das gewünschte Maß der Anhebung bzw. Absenkung auf einfache Art einzustellen.

Nach einer weiteren Ausgestaltung der Erfindung ist vorgesehen, daß mehrere Schaltungsanordnungen mit elektronisch steuerbaren Übertragungsverhalten hintereinander geschaltet sind, mittels derer eine Beeinflussung des Eingangssignals in verschiedenen Frequenzbereichen erfolgt.

Auf diese Weise ist ein Equalizer relativ leicht aufbaubar, für den es besonders vorteilhaft ist, daß auch relativ geringe Frequenzgangbeeinflussungen mit der gleichen Güte vorgenommen werden können, wie größere Beeinflussungen des Frequenzgangs.

Anhand der Zeichnung wird eine Ausgestaltung der erfindungsgemäßen Schaltungsanordnung näher erläutert. Es zeigen:
Fig. 1 ein Prinzipschaltbild einer Schaltungsanordnung mit elektronisch steuerbarem Übertragungsverhalten,
Fig. 2 verschiedene Filterkurven der Schaltungsanordnung gemäß Fig. 1 mit konstanter Güte und
Fig. 3 Filterkurven der Anordnung gemäß Fig. 1 mit verschiedener Güte.

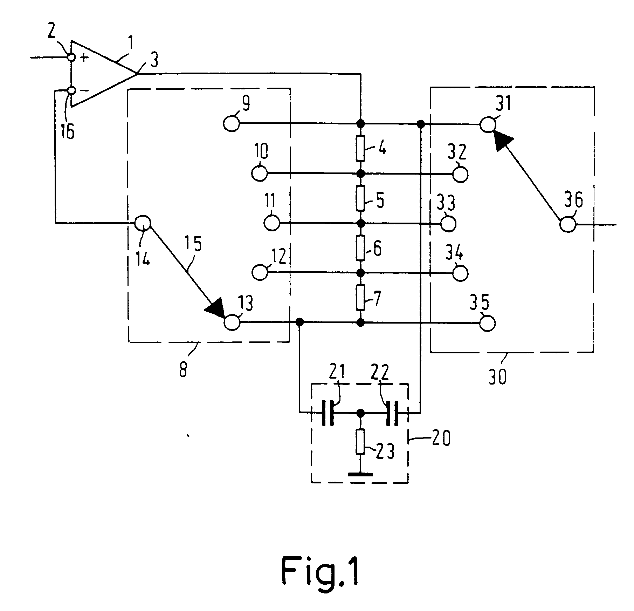

In Fig. 1 ist eine erfindungsgemäße Schaltungsanordnung dargestellt, mittels derer eine Beeinflussung ihres Eingangssignals in einem bestimmten Frequenzbereich vorgenommen werden kann. Eine solche Schaltung ist insbesondere für Audio-Geräte, gegebenenfalls in mehrfach hintereinandergeschalteter Form zur Beeinflussung verschiedener Frequenzbereiche, einsetzbar.

Die in der Fig. 1 dargestellte Schaltungsanordnung weist einen Operationsverstärker 1 auf, dessen nichtinvertierendem Eingang 2 das zu beeinflussende Eingangssignal zugeführt wird. Ein Ausgang 3 des Operationsverstärkers 1 ist mit einer Widerstandskette verbunden, welche aus in Reihe geschalteten Widerständen 4, 5, 6 und 7 besteht.

Es ist ferner ein erster elektronisch steuerbarer Umschalter 8 vorgesehen, welcher fünf Eingangsanschlüsse 9, 10, 11, 12 und 13 sowie einen Ausgangsanschluß 14 aufweist. Der Umschalter selbst ist in der Figur schematisch durch einen Zeiger 15 repräsentiert, mittels dessen einer der Eingänge 9 bis 13 auf den Ausgang 14 geschaltet wird. In der tatsächlichen Realisierung handelt es sich bei dem Umschalter 8 um einen elektronischen Umschalter, der beispielsweise in in der Figur nicht dargestellter Weise von außen durch geeignete Datenworte steuerbar ist.

Der erste Eingang 9 des elektronischen Umschalters 8 ist mit dem Ausgang 3 des Operationsverstärkers 1 verbunden. Der zweite Eingang 10 des Umschalters 8 ist mit dem Verbindungspunkt zwischen den Widerständen 4 und 5, der dritte Eingang 11 mit dem Verbindungspunkt zwischen den Widerständen 5 und 6, der vierte Eingang 12 mit dem Verbindungspunkt zwischen den Widerständen 6 und 7 und der fünfte Eingang 13 des Umschalters 8 ist mit dem Endpunkt der Widerstandskette verbunden. Der Ausgang 14 des ersten Umschalters 8 ist mit einem invertierenden Eingang 16 des Operationsverstärkers 1 verbunden. Je nach Schaltung des ersten Umschalters 8 auf eine der Eingänge 9 bis 13 ist die Gegenkopplung des Operationsverstärkers 1 einstellbar.

Parallel zu der Widerstandskette, bestehend aus den Widerständen 4 bis 7, ist ein frequenzabhängiges Schaltungselement 20 geschaltet. Dieses ist aus zwei in Reihe geschalteten Kondensatoren 21 und 22 aufgebaut, deren Verbindungspunkt über einen Widerstand 23 auf Masse geführt ist. Die Widerstandskette, bestehend aus den Widerständen 4 bis 7, sowie das Schaltungselement 20 bilden die Spannungsteileranordnung mit frequenzabhängigen Verhalten. In dem in der Fig. 1 dargestellten Ausführungsbeispiel ist diese Spannungsteileranordnung so ausgelegt, daß sie das Eingangssignal in einem Frequenzbereich um 1 kHz beeinflußt.

Es ist ferner ein zweiter elektronisch steuerbarer Umschalter 30 vorgesehen, der ähnlich dem ersten Umschalter 8 in der Fig. 1 nur schematisch dargestellt ist und welcher fünf Eingänge 31, 32, 33, 34 und 35 aufweist. Dabei ist der Eingang 31 des zweiten Umschalters 30 in gleicher Weise verschaltet, wie der Eingang 9 des ersten Umschalters 8. Ebenso sind die weiteren Eingänge 32 bis 35 ebenso verschaltet wie die Eingänge 10 bis 13 des ersten Umschalters 8. Die Eingänge 31 bis 35 des zweiten elektronisch steuerbaren Umschalters 30 sind auf dessen Ausgang 36 schaltbar. Mittels des zweiten Umschalters 30 ist das Maß der Auskopplung des an dem Ausgang 36 des zweiten Umschalters 30 gelieferten Ausgangssignals der Schaltungsanordnung einstellbar.

Die in Fig. 1 dargestellte Schaltungsanordnung gestattet eine Anhebung bzw. Absenkung des dem nichtinvertierenden Eingang 2 des Operationsverstärkers 1 zugeführten Eingangssignals in Abhängigkeit der Steuerung der beiden elektronischen Umschalter 8 und 30. Das entsprechende Ausgangssignal wird am Ausgang 36 des zweiten Umschalters 30 zur Verfügung gestellt.

Soll eine Anhebung des Eingangssignals in dem von dem frequenzabhängigen Spannungsteiler bestimmten Frequenzbereich vorgenommen werden, so wird die Breite des Frequenzbereichs, in dem die Anhebung erfolgt, durch die Position des ersten elektronischen Umschalters 8 beeinflußt. Das Maß der Anhebung wird dagegen durch die Position des zweiten elektronischen Umschalters 30 beeinflußt. Umgekehrt wird für den Fall, daß eine Absenkung des Eingangssignals in dem von dem Spannungsteiler bestimmten Frequenzbereich erfolgen soll, die Breite des beeinflußten Frequenzbereichs durch Position des zweiten Umschalters 30 bestimmt, während das Maß der Absenkung durch Position des ersten elektronischen Umschalters 8 beeinflußt wird.

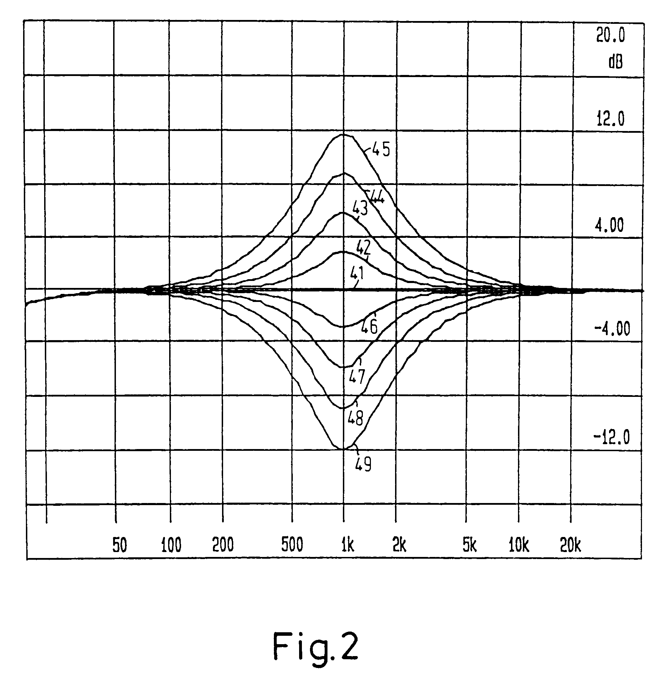

Die Funktionsweise der in Fig. 1 dargestellten Schaltungsanordnung wird im folgenden anhand des Frequenzdiagrammes gemäß Fig. 2 näher erläutert.

Es wird im folgenden davon ausgegangen, daß die Spannungsteileranordnung mit frequenzabhängigem Verhalten, die aus der Widerstandskette mit den Widerständen 4 bis 7 sowie dem frequenzabhängigen Schaltungselement 20 aufgebaut ist, eine Beeinflussung des Frequenzbereiches des Eingangssignals in dem Bereich um 1 kHz vornimmt, wobei die maximale Beeinflussung bei 1 kHz erfolgt.

In Fig. 2 ist eine Kurvenschar dargestellt, welche das Ausgangssignal der Schaltungsanordnung für ein lineares Eingangssignal für verschiedene Position der Umschalter 8 und 30 darstellt. In dem in Fig. 2 dargestellten Beispielsfalle wurde die Schaltungsanordnung gemäß Fig. 1, bzw. deren elektronisch steuerbare Umschalter 8 und 30 so gesteuert, daß auch für geringe Anhebungen bzw. Absenkungen des Eingangssignals in dem Frequenzbereich um 1 KHz Filterkurven mit etwa gleicher Güte entstehen wie für stärkere Anhebungen bzw. Absenkungen.

Für den in der Fig. 2 dargestellten Kurvenverlauf 41, in dem das Eingangssignal praktisch unverändert am Ausgang der Schaltungsanordnung erscheint, ist der erste elektronische Umschalter 8 auf seinen Eingang 13 und der zweite elektronische Umschalter 30 auf seinen Eingang 35 geschaltet. Bei diesen Schalterstellungen der Umschalter 8 und 30 ergibt sich ein linearer Frequenzgang, wie dies in all denjenigen Schalterstellungen der beiden Umschalter gilt, bei denen die Schalter auf denselben Verbindungspunkt in der Widerstandskette geschaltet sind. Der Kurvenverlauf 41 gemäß Fig. 2 wird also beispielsweise auch erzielt, wenn der erste elektronische Umschalter 8 auf seinen Eingang 9 und der zweite elektronische Umschalter 30 auf seinen Eingang 31 geschaltet ist. In diesen Schalterstellungen durchläuft dann das Signal die Spannungsteileranordnung mit frequenzabhängigem Verhalten nicht mehr und die gesamte Schaltungsanordnung weist eine Verstärkung von Null auf.

In der Fig. 2 sind ferner Kurvenverläufe 42 bis 45 dargestellt, bei welchen eine Anhebung des Eingangssignals in dem Frequenzbereich um 1 kHz vorgenommen wird. In dem in der Fig. 2 dargestellten Beispielsfalle wurden diese Kurven so gewählt, daß die Güte der Filterkurven 42 bis 45 etwa gleich ist. Dazu wird in der Schaltungsanordnung gemäß Fig. 1 der erste elektronische Umschalter 8 auf seinen Eingang 13 gesetzt. Der in Fig. 2 dargestellte Kurvenverlauf 42 entsteht dann dadurch, daß der zweite elektronische Umschalter 30 auf seinen Eingang 34 gesetzt wird. Durch Umschalten des zweiten elektronischen Umschalters 30 von seinem Eingang 35 auf seinen Eingang 34 wird die Auskoppeldämpfung verringert, so daß nunmehr das frequenzabhängige Verhalten der Spannungsteileranordnung das Ausgangssignal beeinflußt. Soll eine noch stärkere Anhebung gemäß Kurvenverlauf 43 in der Darstellung gemäß Fig. 2 vorgenommen werden, so wird der elektronische Umschalter 30 auf seinen Eingang 33 gesetzt. Der Kurvenverlauf 44 gemäß Fig. 2 entsteht durch Umschalten des elektronischen Umschalters 30 auf seinen Eingang 32 und der Kurvenverlauf 45 entsteht durch Umschalten des Umschalters auf seinen Eingang 31. Der Kurvenverlauf 45 repräsentiert die maximal mögliche Anhebung des Eingangssignals in dem Frequenzbereich um 1 kHz, die in dem in der Fig. 2 dargestellten Beispiel etwa 12 dB beträgt.

Da bei einer Anhebung des Eingangssignals in dem Frequenzbereich die Güte der entstehenden Filterkurven durch Position des ersten elektronischen Umschalters 8 beeinflußt wird und da dieser für die Filterkurven 42 bis 45 in seiner Position 13 verbleibt, weisen diese Filterkurven auch in etwa die gleiche Güte auf. Das Maß der Anhebung wird durch Einstellung des zweiten elektronischen Umschalters 30 vorgenommen.

In der Fig. 2 sind ferner Filterkurven 46, 47, 48 und 49 dargestellt, welche eine Absenkung des Eingangssignals in dem Frequenzbereich um 1 kHz zeigen.

Da für eine Absenkung des Eingangssignals mit Filterkurven konstanter Güte die Position des zweiten elektronischen Umschalters 30 nicht verändert werden darf, wird für die in der Fig. 2 dargestellte Kurvenschar 46 bis 49 der zweite elektronische Umschalter auf seinen Eingang 35 geschaltet. Das durch die Kurvenschar 46 bis 49 repräsentierte verschieden starke Maß der Absenkung wird vorgenommen durch entsprechende Umschaltung des ersten elektronischen Umschalters 8. Der Kurvenverlauf 46 entsteht, wenn der erste elektronische Umschalter 8 auf seinen Eingang 12 geschaltet ist. Die maximale Absenkung des Eingangssignals in dem Frequenzbereich um 1 kHz entsprechend Kurvenverlauf 49 entsteht, wenn der erste elektronische Umschalter 8 auf seinen ersten Eingang 9 geschaltet ist.

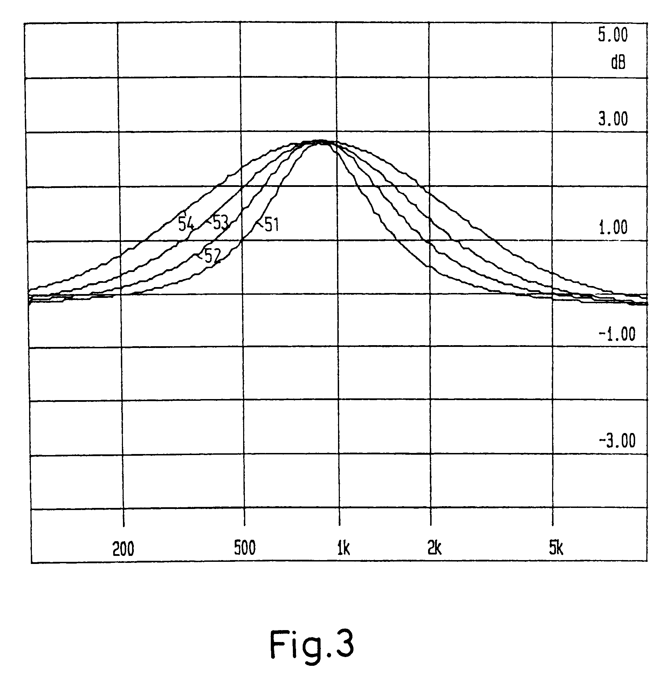

Das in Fig. 2 dargestellte Beispiel wurde so gewählt, daß sowohl eine Anhebung bzw. auch eine Absenkung des Eingangssignals in dem Frequenzbereich immer mit maximal möglicher Güte vorgenommen wird. Dies wird beispielsweise in Equalizern wünschenswert sein, bei denen meist ein möglichst schmaler Frequenzbereich beeinflußt werden soll. Da die erfindungsgemäße Schaltungsanordung es jedoch gestattet, die Güte der mittels ihr erzeugten Filterkurve gezielt einzustellen, besteht auch die Möglichkeit, bei einem bestimmten Maß der Anhebung bzw. Absenkung des Eingangssignals Filterkurven verschiedener Güte einzustellen. In Fig. 3 sind einige Filterkurven dargestellt, wie sie in einem solchen Falle ebenfalls mittels der in Fig. 1 dargestellten Schaltungsanordnung erzeugt werden können.

In Fig. 3 sind vier Filterkurven 51 bis 54 dargestellt, bei denen im Frequenzbereich um 1 kHz jeweils das gleiche Maß der Anhebung des Eingangssignals, nämlich etwa 3 dB, vorgenommen wird. Diese Anhebung erfolgt jedoch in einem verschieden breiten Frequenzbereich, d.h. also mit Filterkurven verschiedener Güte.

Der Kurvenverlauf 51 gemäß Fig. 3 stellt denjenigen mit der maximalen Güte dar, d.h. also denjenigen, bei dem die Anhebung in einem relativ schmalen Frequenzbereich erfolgt. In diesem Falle ist in der Schaltunganordnung gemäß Fig. 1 der erste Umschalter 8 auf seinen Eingang 13 gesetzt, während der zweite elektronische Umschalter 30 auf seinen Eingang 34 gesetzt ist. Zur Erzielung des Kurvenverlaufs 52 gemäß Fig. 3 ist in der Anordnung gemäß Fig. 1 der erste elektronische Umschalter 8 auf seinen Eingang 12 und der zweite elektronische Umschalter 30 auf seinen Eingang 33 geschaltet. Für Kurvenverlauf 53 gemäß Fig. 3 ist der erste elektronische Umschalter 8 auf seinen Eingang 11 und der zweite elektronische Umschalter 30 auf seinen Eingang 32 geschaltet. Zur Erzielung des Kurvenverlaufs 54 gemäß Fig. 3 mit der geringsten Güte, bei dem der beeinflußte Frequenzbereich relativ breit ist, ist der erste elektronische Umschalter 8 der Schaltungsanordnung gemäß Fig. 1 auf seinen Eingang 10 und der zweite elektronische Umschalter 30 auf seinen Eingang 31 gesetzt.

Die Kurvenschar gemäß Fig. 3 zeigt, daß die Güte der erzeugten Filterkurven, d.h. also die Breite des beeinflußten Frequenzbereiches, bei einer Anhebung des Eingangssignals von der Position des ersten Umschalters 8 beeinflußt wird. Dieser erste Umschalter 8 bestimmt das Maß der Gegenkopplung in der Schaltungsanordnung und somit nicht nur die Güte der Filterkurven sondern auch das Maß der Verstärkung. Die in der Fig. 3 dargestellten Filterkurven mit gleichem Maß der Anhebung ist diese verschiedene Gegenkopplung und damit auch verschiedene Verstärkung in der Schaltungsanordnung durch geeignetes Setzen des zweiten Umschalters 30 wieder auszugleichen. Die verschiedenen Positionen des zweiten Umschalters 30 beeinflussen jedoch bei einer Anhebung des Eingangssignals nicht die Güte der entstehenden Filterkurven.

## Patentansprüche

1. Schaltungsanordnung mit elektronisch steuerbarem Übertragungsverhalten, insbesondere Stellerschaltung, wobei das Eingangssignal einem Verstärker mit steuerbarer Gegenkopplung zugeführt wird, an dessen Ausgang eine Spannungsteileranordnung mit frequenzabhängigem Verhalten angeschlossen ist, die mit mehreren Abgriffen (9 bis 13, 31 bis 35) versehen ist, die über einen ersten elektronisch steuerbaren Umschalter (8) mit einem invertierenden Eingang des Verstärkers und über einen zweiten elektronisch steuerbaren Umschalter (30) mit dem Ausgang der Schaltungsanordnung verbunden sind,
dadurch gekennzeichnet, daß die beiden Umschalter (8, 30) so gesteuert sind, daß
a) für eine Anhebung des Eingangssignals in einem von dem frequenzabhängigen Spannungsteiler bestimmten Frequenzbereich
- der erste Umschalter (8) auf eine solche Position gesetzt wird, daß die Anhebung in der gewünschten Frequenzbereichsbreite erfolgt, und daß
- die Position des zweiten Umschalters (30) so gewählt wird, daß die Anhebung in dem gewünschten Maß erfolgt, und daß
b) für eine Absenkung des Eingangssignals in dem von dem frequenzabhängigen Spannungsteiler bestimmten Frequenzbereich
- der zweite Umschalter (30) auf eine solche Position gesetzt wird, daß die Absenkung mit der gewünschten Frequenzbereichsbreite erfolgt, und daß
- der erste Umschalter (8) auf eine solche Position gesetzt wird, daß die Absenkung in dem gewünschten Maße erfolgt.

2. Schaltungsanordnung nach Anspruch 1,
dadurch gekennzeichnet, daß für eine Anhebung des Eingangssignals in dem Frequenzbereich der erste Umschalter (8) auf die Position für minimale Gegenkopplung gesetzt wird, und daß für eine Absenkung des Eingangssignals in dem Frequenzbereich der zweite Umschalter (30) auf diejenige Position gesetzt wird, bei der die größte Dämpfung des Ausgangssignals erfolgt.

3. Schaltungsanordnung nach Anspruch 1 oder 2,
dadurch gekennzeichnet, daß eine mit mehreren Abgriffen (9 bis 13, 31 bis 35) versehene Widerstandskette (4, 5, 6, 7) an den Ausgang des Verstärkers (1) angeschlossen ist, daß zwei in Reihe geschaltete Kondensatoren (21, 22) der Widerstandskette parallel geschaltet sind und daß der Verbindungspunkt zwischen den Kondensatoren über einen Widerstand (23) mit Masse verbunden ist.

4. Schaltungsanordnung nach einem der Ansprüche 1 bis 3,
dadurch gekennzeichnet, daß als Umschalter (8, 30) Halbleiterschaltungen vorgesehen sind, deren Schaltzustände durch digitale Datenworte steuerbar sind.

5. Schaltungsanordnung nach einem der Ansprüche 1 bis 4,
dadurch gekennzeichnet, daß mehrere Schaltungsanordnungen mit elektronisch steuerbaren Übertragungsverhalten hintereinander geschaltet sind, mittels derer eine Beeinflussung des Eingangssignals in verschiedenen Frequenzbereichen erfolgt.

## Claims

1. A circuit arrangement with electronically controllable transfer characteristic, in particular a control circuit, in which an input signal is applied to an amplifier with controllable negative feedback, the output of said amplifier being connected to a voltage-divider circuit with a frequency-dependent characteristic, which circuit has a plurality of taps (9 to 13, 31 to 35) connected to an inverting input of the amplifier *via* a first electronically controllable switch (8) and to the output of the circuit arrangement *via* a second electronically controllable switch (30),
characterised in that the two switches (8, 30) are controlled in such a manner that
a) for boosting the input signal in a frequency band determined by the frequency-dependent voltage divider
- the first switch (8) is set to such a position that boosting is effected with the desired frequency bandwidth, and that
- the position of the second switch (30) is selected so as to obtain boosting to the desired degree, and that
b) for attenuating the input signal in the frequency band determined by the frequency-dependent voltage divider
- the second switch (30) is set to such a position that attenuation is effected with the desired frequency bandwidth, and that
- the first switch (8) is set to such a position that attenuation to the desired degree is obtained.

2. A circuit arrangement as claimed in Claim 1,
characterised in that for boosting the input signal in the frequency band the first switch (8) is set to the position for minimum negative feedback, and in that for attenuating the input signal in the frequency band the second switch (30) is set to that position in which the maximum attenuation of the output signal is obtained.

3. A circuit arrangement as claimed in Claim 1 or 2,
characterised in that a resistor chain (4, 5, 6, 7) having a plurality of taps (9 to 13, 31 to 35) is connected to the output of the amplifier (1), in that two series-connected capacitors (21, 22) are arranged in parallel with the resistor chain, and in that the node between the capacitors is connected to earth *via* a resistor (23).

4. A circuit arrangement as claimed in any one of the Claims 1 to 3,
characterised in that the switches (8, 30) are semiconductor circuits whose switching states are controllable by digital data words.

5. A circuit arrangement as claimed in Claim 1, 2, 3 or 4, characterised in that a plurality of circuit arrangements with electronically controllable transfer characteristics are arranged after one another, by means of which the input signal is influenced in different frequency bands.

## Revendications

1. Montage de circuit à caractéristique de transmission commandée par voie électronique, en particulier circuit de réglage, dans lequel le signal d'entrée est acheminé à un amplificateur à contre-réaction commandée, à la sortie duquel est raccordé un dispositif diviseur de tension à caractéristique fonction de la fréquence, qui est équipé de plusieurs prises (9 à 13, 31 à 35), qui sont connectées, via un premier commutateur (8) commandé par voie électronique, à une entrée inverseuse de l'amplificateur et, via un deuxième commutateur (30) commandé par voie électronique, à la sortie du montage de circuit, caractérisé en ce que les deux commutateurs (8, 30) sont commandés, de telle sorte que :
a) pour une augmentation du signal d'entrée dans une plage de fréquences déterminée par le diviseur de tension fonction de la fréquence,
- le premier commutateur (8) soit commuté dans une position telle que l'augmentation se fasse dans la largeur souhaitée de la plage de fréquences, et que
- la position du deuxième commutateur (30) soit choisie, de telle sorte que l'augmentation se fasse dans la mesure souhaitée, et que
b) pour une diminution du signal d'entrée dans la plage de fréquences déterminée par le diviseur de tension fonction de la fréquence,
- le deuxième commutateur (30) soit commuté dans une position telle que la diminution se fasse avec la largeur souhaitée de la plage de fréquences, et que
- le premier commutateur (8) soit commuté dans une position telle que la diminution se fasse dans la mesure souhaitée.

2. Montage de circuit selon la revendication 1, caractérisé en ce que, pour une augmentation du signal d'entrée dans la plage de fréquences, le premier commutateur (8) est commuté dans la position de contre-réaction minimale et que, pour une diminution du signal d'entrée dans la plage de fréquences, le deuxième commutateur (30) est commuté dans la position dans laquelle l'amortissement du signal de sortie le plus important se produit.

3. Montage de circuit selon la revendication 1 ou 2, caractérisé en ce qu'une chaîne de résistances (4, 5, 6, 7) pourvue de plusieurs prises (9 à 13, 31 à 35) est raccordée à la sortie de l'amplificateur (1), en ce que deux condensateurs (21, 22) connectés en série sont connectés en parallèle à la chaîne de résistances, et en ce que le point de liaison entre les condensateurs est relié à la masse via une résistance (23).

4. Montage de circuit selon l'une quelconque des revendications 1 à 3, caractérisé en ce que comme commutateurs (8, 30) sont prévus des circuits à semi-conducteurs, dont les états de commutation peuvent être commandés par des mots de données numériques.

5. Montage de circuit selon l'une quelconque des revendications 1 à 4, caractérisé en ce que plusieurs montages de circuit ayant des caractéristiques de transfert commandées par voie électronique sont connectés en cascade de manière à influencer le signal d'entrée dans diverses plages de fréquences.
